# EUROPEAN PATENT APPLICATION

(11) **EP 2 903 023 A1**
(43) Date of publication of application: **05.08.2015**
(21) Application number: 15152976.5
(22) Date of filing: 29.01.2015
(51) Int. Cl.: H01L 23/49, H01L 23/373, H01L 25/07

(54) **Power semiconductor module**

(30) Priority: 30.01.2014 JP 2014015049
(71) Applicant: Hitachi Power Semiconductor Device, Ltd., Hitachi-shi, Ibaraki 319-1221 (JP)
(72) Inventor: Motowaki, Shigehisa, Tokyo, 100-8280 (JP); Houzouji, Hiroshi, Tokyo, 100-8280 (JP); Morita, Toshiaki, Tokyo, 100-8280 (JP); Konno, Akitoyo, Tokyo, 100-8280 (JP)
(74) Representative: MERH-IP Matias Erny Reichl Hoffmann

(57) **Abstract**

To provide a power semiconductor module that can efficiently cool a high-heat-generating portion of a transistor device and has excellent connection reliability of a wiring bonding portion. A power semiconductor module includes: a heat sink (1); a circuit board connected to the heat sink (1) via a bondingmaterial and formed with a wiring on a front surface of an insulating substrate (2); a transistor device (5) including a main electrode (6) and a control electrode (7) formed on one surface and a back surface electrode formed on the other surface, the back surface electrode being connected to the circuit board via a bonding material; a first conductive member (10) bonded to the main electrode (6) via a bonding material; and wire or ribbon-shaped connection terminals (11) and (12) that electrically connect the first conductive member (10) and the control electrode (7) with another device or the circuit board, wherein the control electrode (7) is disposed at a corner portion of the main electrode (6), and the first conductive member (10) has a shape in which the first conductive member is cut out at a portion above the control electrode (7).

## Description

### [Technical Field]

The present invention relates to a power semiconductor module such as an IGBT module, and more particularly to a power semiconductor module in which a wiring is formed of a wire or ribbon on a plate-like conductive member disposed on a semiconductor device.

### [Background Art]

A power semiconductor module such as an IGBTmodule handles a large current of several tens to several hundreds amperes per semiconductor device, which involves large heat generation of semiconductor devices. In recent years, further downsizing of the power semiconductor module is demanded, and the heat generation density tends to be increasing more and more. The semiconductor device composed of Si or SiC is connected with another device or an electrode by means of a wire, a ribbon, or the like composed of copper or aluminum. However, since there is a difference in thermal expansion rate between the semiconductor device and the wiring material, there is a problem in that a bonding portion is broken due to thermal fatigue during repetition of switching operations (ON and OFF operations for energization).

Therefore, as a technique for improving the reliability of wiring connection, PTL 1 discloses a power semiconductor module having a structure in which a heat-diffusing metal plate is connected on a semiconductor chip by means of solder, and the heat-diffusing metal plate and a wiring pattern on an insulating substrate are connected by means of a thin metal (ribbon) having a thickness of about 100 to 200 µm. It is described in PTL 1 that the heat-diffusing metal plate provides an effect of equalizing the heat in the semiconductor chip in which the temperature is elevated at the central portion. Similarly, as a technique for improving the reliability of wiring connection using a conductive metal plate, there is PTL 2. PTL 2 presents a solution from the viewpoint of stress buffer, in which two metal plates having a thermal expansion coefficient intermediate between a wiring member and a semiconductor device are used to eliminate a connecting portion having a large difference in thermal expansion coefficient.

That is, if a material having a proper thermal expansion coefficient is used, the heat-diffusing metal plate connected on the semiconductor chip via a bonding material is a dominant connection reliability improving means that can equalize the temperature distribution of the chip and reduce the thermal stress of a wiring bonding portion.

### [Citation List]

### [Patent Literature]

[PTL 1] JP-A-2013-197560
[PTL 2] JP-A-2012-28674

### [Summary of Invention]

### [Technical Problem]

However, the heat-diffusing metal plate having the conventional structure is not optimized for a layout in a planar direction along the chip surface in view of heat diffusion and bonding layout. For example, in an IGBT device (insulated gate bipolar transistor), an emitter electrode (main electrode) and a gate electrode (control electrode) are formed in a front surface electrode, and a collector electrode (main electrode) is formed in a back surface electrode. A gate current only flows for a short time in turning on and off, and the amount of the current that instantaneously flows is only about one several tenth to one several hundredth of the current that flows between the emitter and the collector. Therefore, the amount of heat generation of the gate electrode is small relative to that of the emitter electrode, so that especially the emitter electrode has to be efficiently cooled. However, in the conventional structures described in PTLs 1 and 2, although the conductive member connected on the emitter electrode and the gate wiring are described, they are only placed side by side. Therefore, there is a problem in that a detailed layout on the chip for efficiently cooling a high-heat-generating portion is not optimized.

Also in a MOSFET device (insulated gate field-effect transistor) in which a source electrode (main electrode) and a gate electrode (control electrode) are formed in a front surface electrode and a drain electrode (main electrode) is formed in a back surface electrode, the amount of current that flows between the main electrodes is larger than the amount of current that flows through the gate electrode, and therefore, a high-heat-generating portion and a low-heat-generating portion are included. How to efficiently cool the high-heat-generating portion is a common problem to transistor devices.

It is an object of the invention to provide a power semiconductor module that can efficiently cool a high-heat-generating portion of a transistor device and has excellent connection reliability of a wiring bonding portion.

### [Solution to Problem]

One configuration of the invention for solving the problem is directed to "a power semiconductor module including: a heat sink; a circuit board connected to the heat sink via a bonding material and formed with a wiring on a front surface of an insulating substrate; a transistor device including a main electrode and a control electrode formed on one surface and a back surface electrode formed on the other surface, the back surface electrode being connected to the circuit board via a bonding material; a first conductive member bonded to the main electrode via a bonding material; and wire or ribbon-shaped connection terminals electrically connecting the first conductive member and the control electrode with another device or the circuit board, wherein the control electrode is disposed at a corner portion of the main electrode, and the first conductive member has a shape in which the first conductive member is cut out at a portion above the control electrode". When the structure is adopted, in which the control electrode is disposed at the corner portion of the main electrode, the first conductive member is connected to the main electrode, and the first conductive member has the shape in which the first conductive member is cut out at the portion above the control electrode, the main electrode as a high-heat-generating portion relative to the control electrode can be covered in maximum area with the conductive member continuously and without a hole or groove, a heat conduction path is not interrupted in the conductive member, and thus a high heat-equalizing effect is obtained.

### [Advantageous effects of Invention]

According to the invention, it is possible to provide a power semiconductor module that can efficiently cool a high-heat-generating portion of a transistor device and has excellent connection reliability of a wiring bonding portion.

### [Brief Description of Drawings]

[Figs. 1] Figs. 1 are perspective views showing a configuration of a power semiconductor module as one embodiment of the invention.
[Figs. 2] Figs. 2 are perspective views showing a configuration of a power semiconductor module as one embodiment of the invention.
[Figs. 3] Figs. 3 are a top view and a cross-sectional view showing a configuration of a power semiconductor module as one embodiment of the invention.
[Figs. 4] Figs. 4 are a top view and a cross-sectional view showing a configuration of a power semiconductor module using a conventional wiring method.
[Fig. 5] Fig. 5 is a top view showing a configuration of a power semiconductor module as one embodiment of the invention.
[Fig. 6] Fig. 6 is a top view showing a configuration of a power semiconductor module as one embodiment of the invention.
[Fig. 7] Fig. 7 is a top view showing a configuration of a power semiconductor module as one embodiment of the invention.
[Fig. 8] Fig. 8 is a top view showing a configuration of a power semiconductor module as one embodiment of the invention.

### [Description of Embodiments]

Hereinafter, examples will be described with reference to the drawings.

### [Example 1]

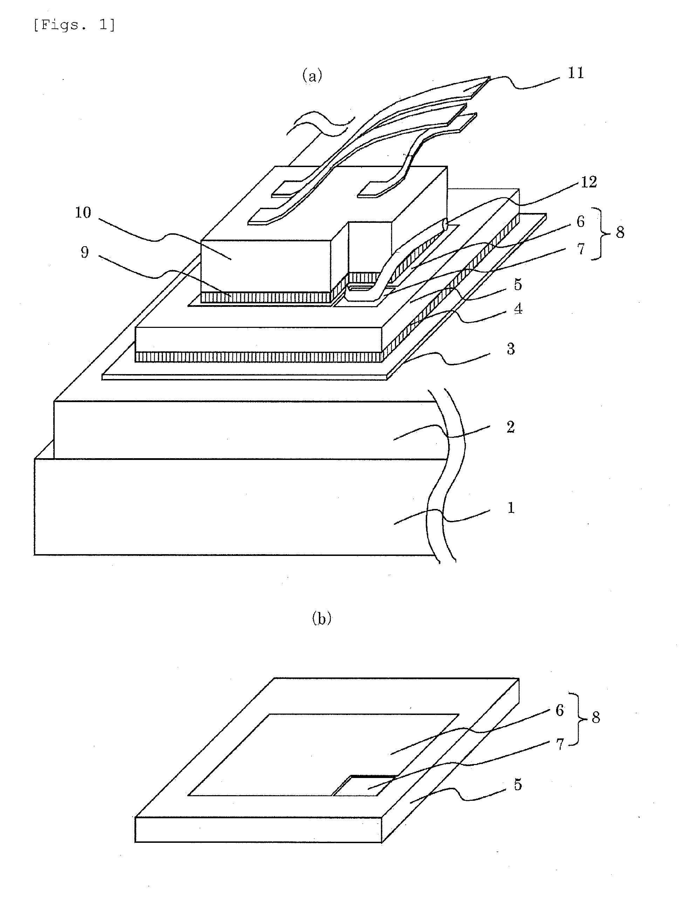

Figs. 1 show a perspective view showing a configuration of a power semiconductor module as one embodiment of the invention. Fig. 1(a) shows a stacked structure, and Fig. 1(b) illustrates only a transistor device for simply showing an electrode arrangement of the transistor device. In Fig. 1(a), a circuit board is bonded to a heat sink 1 formed of copper, AlSiC, or the like via a bonding material (not shown) such as solder. For an insulating substrate 2 constituting the circuit board, aluminum nitride, silicon nitride, alumina, or the like is used, a wiring pattern 3 made of a metal conductor such as aluminum or copper is bonded to a front surface by brazing or the like, and metal foil made of a metal conductor such as aluminum or copper is bonded to a back surface by brazing or the like.

A transistor device 5 is bonded on the wiring pattern 3 via a bonding material 4. For the bonding material, solder, or a sintering paste of fine particles of silver or copper is used. A paste of fine particles of silver oxide or copper oxide from which silver or copper is generated by reduction can also be used. According to the kind of the bonding material, silver or nickel plating is applied to the wiring pattern 3 for improving the wettability of the bonding material or ensuring bonding strength. For the transistor device 5, Si or SiC is used as a material, and an IGBT (Insulated Gate Bipolar Transistor) or MOSFET (Metal Oxide Semiconductor Field-Effect Transistor) is used as the kind of the device. Here, a main electrode 6 and a control electrode 7 are formed on a front surface of the transistor device 5 as in Fig. 1(b). Although not shown in the drawing, another main electrode is formed on a back surface.

In an IGBT device, an emitter electrode (main electrode) and a gate electrode (control electrode) are formed in a front surface electrode, and a collector electrode (main electrode) is formed in a back surface electrode. In a MOSFET device, a source electrode (main electrode) and a gate electrode (control electrode) are formed in a front surface electrode, and a drain electrode (main electrode) is formed in a back surface electrode. For example, for using an IGBT device as an inverter device, the inverter device is configured as a module in which a plurality of IGBT devices and diode devices are combined together. In Figs. 1, however, the diode device is not shown for simplification.

Here, a conductive member 10 is connected on the main electrode 6 via a bonding material 9. Connection terminals 11 composed of aluminum, copper, or a clad material of aluminum and copper are connected on the conductive member 10 using an ultrasonic bonding machine, and connected with the wiring pattern 3 on the circuit board, another semiconductor device, or the like. In the embodiment of the invention, the control electrode 7 is disposed at a corner portion of the main electrode 6. Moreover, the conductive member 10 is designed to be located closest to the inside of a guard ring so that the main electrode 6 of the transistor device on the front surface electrode side is covered in maximum area, but the conductive member has a structure in which a cutout is provided only above the control electrode 7. A connection terminal 12 composed of aluminum, copper, or a clad material of aluminum and copper is connected on the control electrode 7 using an ultrasonic bonding machine, and connected with the wiring pattern 3 on the circuit board.

The main electrode 6 and the control electrode 7 are covered with a thin film having a thickness of several micrometers, such as aluminum, nickel, gold, silver, or copper, for bonding with the conductive member 10 or ultrasonic bonding with the connection terminal 12. For the material of the bonding material 9, solder, a sintering paste of fine particles of silver or copper, or the like, is used similarly to the material of the bonding material 4.

In the case of using, for the conductive member 10, a material having a thermal conductivity higher in a direction horizontal to the electrode surface of the transistor device than in a direction vertical to the electrode surface, before heat generated by the device is conducted to a wiring such as a wire or ribbon at the upper portion, the heat is diffused in the plane of the conductive member 10 along the chip surface, and a favorable heat-equalizing effect is obtained. Therefore, the wire or ribbon does not peel off due to elevation of temperature only at a specific portion of the chip, so that the wiring connection reliability is improved in the entire chip. For example, a composite material of metal (copper, aluminum, or the like) and a graphite fiber having thermal conductivity anisotropy such as of 20 W/mK in a certain plane and 2000 W/mK in the orthogonal direction of the plane can be used. Moreover, it is further preferable to use a material obtained by stacking layers having different thermal conductivities, such as a clad material of copper/invar/copper. One reason for this is that since the thermal conductivity of invar (iron-nickel alloy) is 13 W/mK, which is lower than 400 W/mK of copper, the heat generated by the transistor device is less likely to be conducted to the upper portion, and the heat conducts through copper along the device surface and is equalized. Another reason is that the thermal expansion rate can be adjusted to a preferable value intermediate between Si or SiC (3 to 5 ppm/K) and the wiring material (Al about 23 ppm/K and Cu about 16 ppm/K) due to the ratio of copper (about 16 ppm/K) and invar (about 1 ppm/K), and thus thermal stress can be reduced. For example, by setting the ratio of copper/invar/copper to 1: 1: 1, a thermal expansion rate of about 11 ppm/K is obtained, making of a connecting portion of materials having a large thermal expansion difference can be avoided, and both the wiring connection reliability and the connection reliability of the conductive member to the chip can be improved.

Although, in the power semiconductor module, a wire having a diameter of 200 to 500 µm or a ribbon having a thickness of 100 to 300 µm is used for allowing large current to flow into the main electrode, it is particularly preferable to use a clad material of copper/invar/copper having a total thickness of 1 mm or more so that the stress strain of a connecting portion between the wiring and the clad material of copper/invar/copper does not overlap the stress strain of a connecting portion between the clad material of copper/invar/copper and the transistor device. Also in terms of relaxing an impact on the chip when cutting the wire or ribbon, it is preferable to use a clad material having a thickness of 1 mm or more. As the material of the conductive member 10, a clad material of copper /molybdenum/copper can also be used other than the cladmaterial of copper/invar/copper. In the example of Figs. 1, the ribbons are connected on the conductive member on the main electrode. A wire may also be used, but the chip is less likely to be damaged by impacts caused by ultrasonic bonding and cutting because of the presence of the conductive member 10, and thus connection is possible by means of a copper ribbon having a width of 1 mm or more. On the other hand, since a conductive member is not provided for the control electrode and bonding is directly performed on the electrode, a wiring material that can be bonded with a low load and low power, such as an aluminum wire, a copper/aluminum clad ribbon, or a narrow-width copper wire, is suitable.

Next, an advantageous effect obtained due to the fact that the control electrode 7 is located at the corner portion of the main electrode 6 and that the conductive member 10 has a structure in which the conductive member is cut out at a portion above the control electrode 7 will be described. In a MOSFET device, a gate electrode insulated by an oxide film (SiO₂) exists, and capacitive components are included. These are referred to as a gate-source capacitance and a gate-drain capacitance. Then, turning on or off is performed with a gate voltage, and a gate current flows at the time of turning on or off. This current, which is used for charging and discharging the gate-source capacitance and the gate-drain capacitance, is small and only one several tenth of the amount of current that flows between the source and the drain. An IGBT device structurally contains the MOSFET, in which a gate current flows only instantaneously and the amount of current is small. As described above, since the current that flows through the control electrode (gate electrode) is smaller than that of the main electrodes (emitter electrode-collector electrode or source electrode-drain electrode) and flows only for a short time, the control electrode is a low-heat-generating portion and the main electrode is a high-heat-generating portion. Actually, the main electrode 6 occupies the most part of a front surface electrode 8 in terms of area in many cases, and a temperature difference of 20 to 30°C occurs even in the main electrode 6 depending on a driving temperature. Although the conductive member 10 is effective for heat equalization, a high heat-equalizing effect is obtained when the control electrode 7 is disposed at a corner portion and the main electrode 6 is continuously covered with the conductive member 10. Conversely, it is not preferable to dispose the control electrode at the chip center because a heat conduction path is interrupted.

Moreover, when the conductive member is connected on the main electrode but the conductive member is not connected to the control electrode as shown in Figs. 1, the following advantage is also provided. That is, when the conductive member is used only for the main electrode 6, the conductive member 10 may be a three-dimensional obstacle in ultrasonic bonding in connection of the wire or ribbon of the control electrode 7. In a tool for conducting ultrasonic vibration, a part for supplying a wire (ribbon), called a guide, and a part for cutting the wire (ribbon), called a cutter, are attached spaced apart from each other at the front and back of the tool, the tip portion is narrow, and the upper portion is thick. Taking a general ultrasonic bonding machine as an example, when the conductive member 10 has a thickness of 1 mm, clearances of, for example, about 2 mm on the guide side and 1 mm on the cutter side with the tool center as a starting point have to be provided for avoiding collision in ultrasonic bonding. If the control electrode 7 is located at the chip center, a hole having a width of 3 mm at a minimum is needed. In view of the extension of the hole in the loop direction of the wire (ribbon), the area of the conductive member 10 has to be greatly reduced, which is disadvantageous in the aspect of heat equalization. When the control electrode 7 is disposed near the center of the main electrode 6 as described above, it is necessary for the main electrode to keep a distance from the control electrode in any of forward, back, left, and right directions. As a result, the area of the conductive member is reduced, so that there is a problem in that a sufficient heat diffusion effect is not obtained. In contrast, by providing the control electrode 7 at the corner portion of the main electrode 6 as in this example, three-dimensional interference due to the conductive member 10 can be minimized. As a result, since there is no need to greatly reduce the size of the conductive member 10, a heat-equalizing effect is not impaired.

According to the example, the electrodes and the conductive member bonded to the electrode can be configured to have the most excellent chip heat equalization in consideration of the presence of a difference in heat generation amount between the main electrode and control electrode of the transistor device, so that it is possible to provide a power semiconductor module having high wiring connection reliability when operating at a high temperature.

### [Example 2]

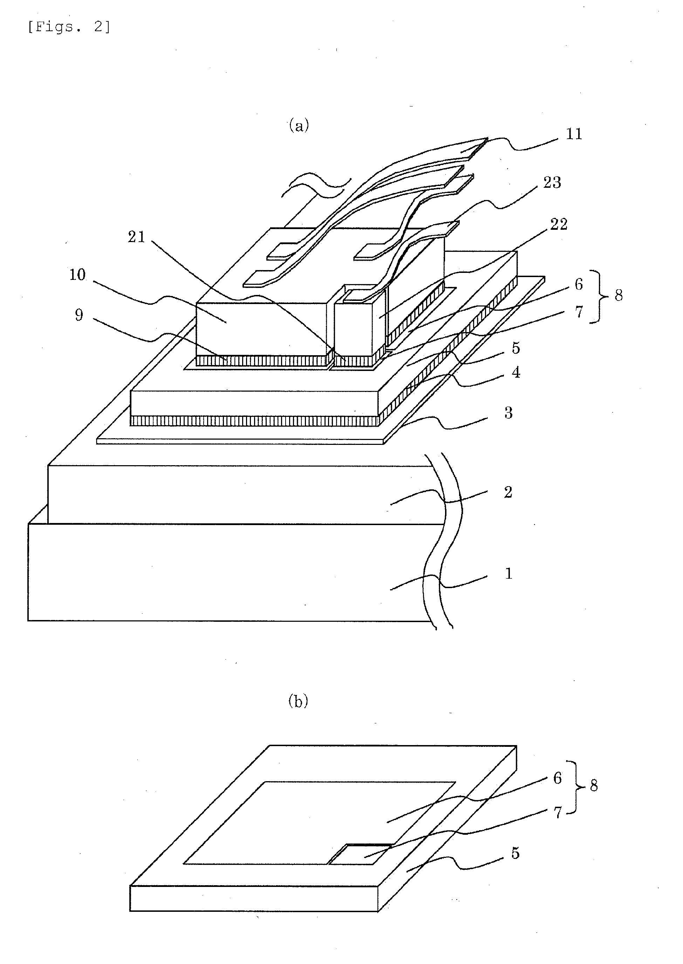

In this example, an example of a power semiconductor module in which a conductive member is also provided on the control electrode 7 will be described using Figs. 2. In Figs. 2, descriptions of portions having the same functions as those of the configurations denoted by the same reference numerals and signs and shown in Figs. 1 that have been already described are omitted.

In this configuration, a conductive member 22 is bonded to the control electrode 7 via a bonding material 21. For the bonding material 21, solder, or a sintering paste of fine particles of silver or copper is used, similarly to the bonding material 9. Similarly to the conductive member 10, in the case of using, for the conductive member 22, a material having a thermal conductivity higher in the direction horizontal to the electrode surface of the transistor device than in the direction vertical to the electrode surface, before heat generated by the device is conducted to a wiring such as a wire or ribbon at the upper portion, the heat is diffused in the plane of the conductive member along the chip surface, and a favorable heat-equalizing effect is obtained. Therefore, the wire or ribbon does not peel off due to elevation of temperature only at a specific portion of the chip, so that the wiring connection reliability is improved in the entire chip. It is particularly preferable to use a material obtained by stacking layers having different thermal conductivities, such as a clad material of copper/invar/copper. A connection terminal 23 composed of aluminum, copper, or a clad material of aluminum and copper is connected to the conductive member 22 using an ultrasonic bonding machine, and connected with the wiring pattern on the circuit board, another semiconductor device, or the like. Because of the presence of the conductive member 22, the chip is less likely to be damaged by impacts caused by ultrasonic bonding and cutting, and thus connection is possible by means of a copper ribbon having a width of 1 mm or more.

In this configuration, the control electrode 7 is located at the corner portion of the main electrode 6, the main electrode 6 is covered with the conductive member 10 not having a hole or groove that interrupts a heat conduction path, and therefore, a high heat-equalizing effect is obtained. Moreover, when the connection terminal 23 is ultrasonic-bonded to the conductive member 22 on the control electrode 7, the conductive member 10 is not an obstacle unlike the configuration in Figs. 1. Therefore, since there is no need to keep a distance from the bonding portion of the connection terminal 23 by reducing the size of the conductive member 10, a high heat-equalizing effect due to the conductive member 10 is obtained.

### [Example 3]

In this example, an example of a power semiconductor module including a plurality of transistor devices and a plurality of diode devices mounted therein and having an excellent heat-equalizing property in the entire module will be described.

In general, power devices handle a plurality of transistors and a plurality of diodes while making the transistors and diodes into a module to realize downsizing, an improvement in mountability, and the like. When a wiring pattern of a circuit board and an device, or devices are connected by means of a connection terminal such as a wire, cutting of the wire on a chip means exertion of an impact on the chip with the cutter of the ultrasonic bonding machine, and therefore, the cutting on the chip is avoided in many cases. Therefore, a wiring pattern of a circuit board and a transistor, the transistor and a diode, and the diode and the wiring pattern of the circuit board are usually connected continuously by means of an aluminum wire having a diameter of 0.4 to 0.5 mm using a wedge bonding type ultrasonic bonding machine.

On the other hand, in the progress of higher capacity and higher heat generation density of power semiconductor modules, copper has attracted attention as a wire material. Since copper has a thermal conductivity and an electrical conductivity higher than those of aluminum, and has a thermal expansion rate close to that of Si or SiC, copper is advantageous also in terms of stress. As described above, a copper-containing wire or ribbon such as of copper or a clad of copper and aluminum is a dominant connection reliability improving means that has an excellent heat transfer property, equalizes the temperature distribution of the entire module, and simultaneously can reduce the thermal stress of a wiring bonding portion. However, since copper is harder than aluminum, copper is less likely to be crashed in ultrasonic bonding, a high load and high power have to be applied, and thus the chip is likely to be damaged. Moreover, when the wiring pattern of the circuit board and the transistor, the transistor and the diode, and the diode and the wiring pattern of the circuit board are continuously connected as in the conventional case, the connection has to be a straight connection because copper is hard and thus less likely to be bent in the chip surface direction. Therefore, the number of copper wirings or the wiring direction is limited.

In contrast, when a conductive member is provided on the electrode of a transistor or diode as in Example 1 or 2, the conductive member acts as an impact buffer in ultrasonic bonding. Therefore, connection using the copper-containing wire or ribbon or cutting thereof is possible on the chip surface, and it is possible to adopt a wiring method with an excellent heat-equalizing property in the entire module. This will be specifically described using the drawings.

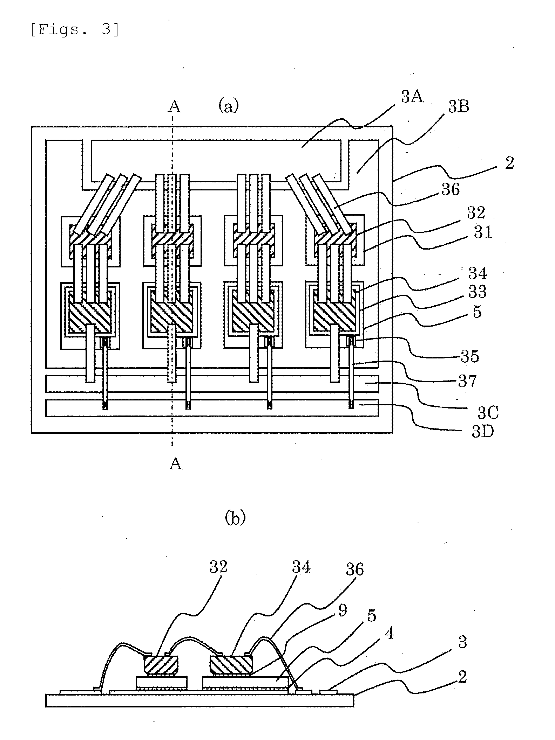

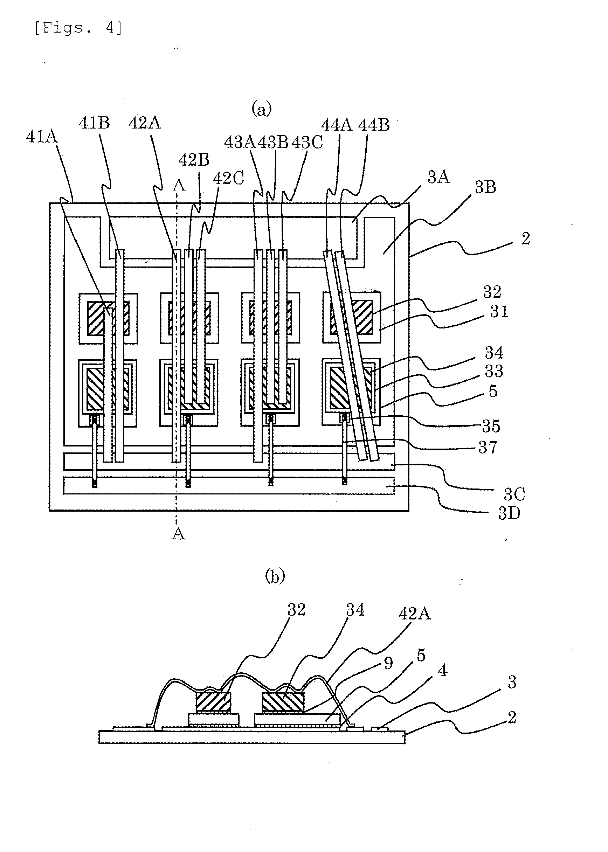

Fig. 3 (a) is a top view of the power semiconductor module of this example, and Fig. 3(b) shows a cross-sectional view of a dot-dash-line portion indicated by A-A. Moreover, for comparison, Fig. 4 (a) shows a top view of a power semiconductor module using a conventional wiring method, and Fig. 4 (b) shows a cross-sectional view of a dot-dash-line portion indicated by A-A. In Figs. 3 and 4, descriptions of portions having the same functions as those of the configurations denoted by the same reference numerals and signs and shown in Figs. 1 and 2 that have already described are omitted.

In Fig. 3(a), the wiring pattern 3 (3A, 3B, 3C, and 3D) that is defined into four blocks insulated from each other is formed on the insulating substrate 2. In Fig. 3(b), a diode device 31 and the transistor device 5 are bonded on the wiring pattern 3 using the bonding material 4 (not shown in the top view) formed of a sintering paste of fine particles of copper. A bonding material such as solder or a paste of fine particles of silver may be used. In Fig. 3(a), four diode devices 31 and four transistor devices 5 are laterally arranged in each line and mounted. In Fig. 3(b), a conductive member 32 and a conductive member 34 are bonded to a front surface electrode of the diode device 31 and a front surface electrode-side main electrode 33 of the transistor device 5, respectively, using the bonding material 9 (not shown in the top view) formed of a sintering paste of fine particles of copper. It is preferable for the conductive members 32 and 34 to use a material having a thermal conductivity higher in the direction horizontal to the electrode surface of the transistor device than in the direction vertical to the electrode surface, and it is particularly preferable to use a material obtained by stacking layers having different thermal conductivities. In this example, a material having a copper/invar/copper thickness ratio of 1:1:1 and a total thickness of 1 mm is used. With the use of the same sintering paste of fine particles of copper for the bonding material 4 and the bonding material 9, bonding of the diode device 31 with the conductive member 32, and bonding of the transistor device 5 with the conductive member 34 are simultaneously performed. For sintering of copper fine particles, if pressurization is not performed simultaneously with heating, the sintered density is not improved. When the simultaneous bonding is performed, if the area of the conductive member is smaller than that of the device, a surface pressure below the conductive member is higher than a surface pressure below the device, and the device is likely to be broken at the edge of the conductive member. Therefore, the surfaces of the conductive members 32 and 34 on the device side are chamfered. As shown in Figs. 3(a) and (b), the wiring pattern 3A and the conductive member 32, the conductive member 32 and the conductive member 34, and the conductive member 34 and the wiring pattern 3C are connected to each other by means of connection terminals 36 respectively formed of independent copper ribbons using an ultrasonic bonding machine. A control electrode 35 of the transistor device 5 and the wiring pattern 3D are connected by means of a connection terminal 37 formed of an aluminum wire using an ultrasonic bonding machine. Since the connection terminal 37 is ultrasonic-bonded to the chip surface without a conductive member, an impact in bonding is likely to damage the chip, and therefore, an aluminum wire that can be deformed with a lower load and lower power than those for copper is used. The insulating substrate 2 is bonded to the heat sink, accommodated in a resin case together with external terminals, and sealed by silicone gel or the like, but these are not shown in the drawings to avoid complexity of the drawings.

In the conventional example of Figs. 4, a stacked structure from the insulating substrate 2 to the conductive members 32 and 34 is common with that of the example of Figs. 3, but a wiring method is different. As in Fig. 4(a), the wiring pattern 3A, the conductive members 32, the conductive members 34, and the wiring pattern 3C are connected by means of connection terminals 41, 42, 43, and 44 each formed of a continuous line that is not cut in the middle. Fig. 4(b) shows a cross-sectional view including a connection terminal 42A. A ribbon forms small arcs, called stitch bonding, on the conductive members 32 and 34, and is not cut on the conductive members 32 and 34. The wire connection method using the continuous line described above has been widely used because when wire bonding is directly performed on the chip electrode surface without mounting a conductive member, a crack occurs in the chip if the wire is cut on the chip surface, and thus cutting is performed on the circuit board. When a conductive member is mounted on the chip, the conductive member acts as an impact buffer in ultrasonic bonding, and therefore, connection by means of a copper-containing wire or ribbon is possible. However, there arises a new problem. Since copper is hard, it is difficult to bend copper when the copper wire or ribbon moves from one connection point to next angled connection point. For example, in Fig. 4(a), the connection terminal 42 connects the wiring pattern 3A and the conductive member 32 with three ribbons, but the connection terminal 41 can connect the wiring pattern 3A and the conductive member 32 with only one ribbon 41B because of a restriction on the electrode width of the wiring pattern 3A. Alternatively, it is also possible to perform ribbon bonding at an angle relative to the chip like the connection terminal 44, but the wiring pattern 3A and the conductive member 32 can be connected with only two ribbons 44A and 44B. Such a reduction in the number of ribbons brings about the concentration of current, and also prevents heat equalization in the module caused by heat transfer through the ribbon, which is not preferable. This example solves such a problem, in which, like the connection terminal 36 in Fig. 3(a), the wiring pattern 3A and the conductive member 32, the conductive member 32 and the conductive member 34, and the conductive member 34 and the wiring pattern 3C are connected by means of connection terminals that are completely independent of each other. Due to this, it is possible to perform wire connection such that a copper ribbon is bonded, between the wiring pattern 3A and the conductive member 32, at an angle of 30 degrees relative to the chip, and that a copper ribbon is attached in accordance with the chip (in a direction of 0 degrees) between the conductive member 32 and the conductive member 34. This makes it possible to connect the wiring pattern 3A and the conductive member 32 with three ribbons, while the continuous line can connect them with only one or two ribbons. Therefore, it is possible to realize heat equalization of the module and freedom in chip arrangement. When the diode device has a different size from the transistor device, or the number of mounted diode devices is different from that of mounted transistor devices, it is very difficult in terms of layout to perform wire connection by means of a substantially linear copper-containing wire or ribbon. Therefore, the wire connection by means of a plurality of independent copper-containing wires or ribbons of the invention is particularly effective. The absence of performing stitch bonding on the conductive member 32 or 34 reduces the heat conduction path, but it is easy to increase the thickness of the conductive member by the amount corresponding to the thickness of the wire or ribbon, so that the absence of performing stitch bonding is not a limiting factor for heat transfer.

According to this example as described above, a circuit board and a conductive member, and the conductive member and another conductive member can be connected by means of copper-containing wire or ribbon-shaped connection terminals that are independent of each other. This independent wire connection makes it possible to attach a copper-based wire (ribbon) between a transistor and a diode in a direction greatly different from a copper-based wire (ribbon) direction between a circuit board and a transistor device. Therefore, even when the electrode pattern and the chip position are misaligned, a reduction in the number of copper-based wires (ribbons) can be avoided. This greatly contributes to heat equalization in the entire module.

### [Example 4]

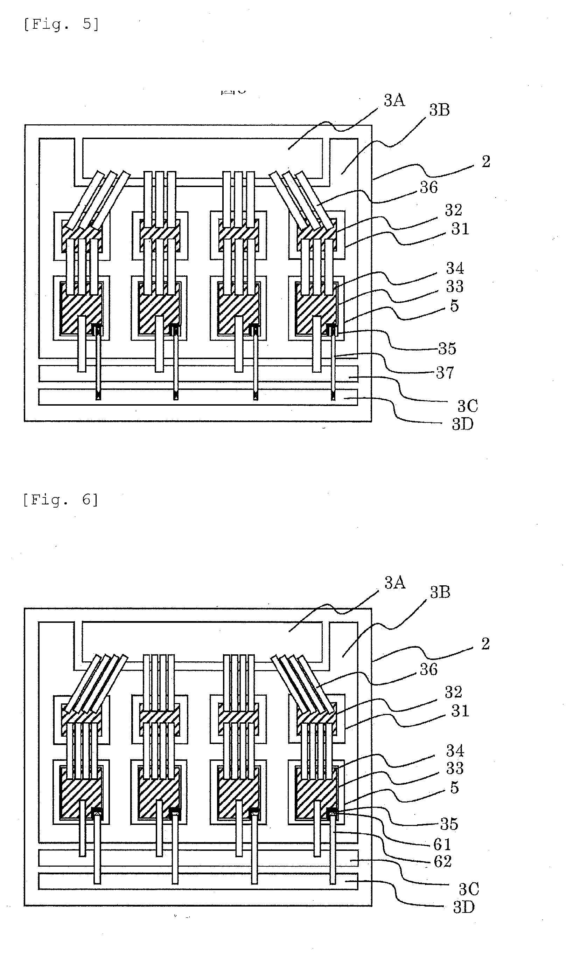

Fig. 5 shows a top view of a power semiconductor module as further another embodiment of the invention. Members used are common with those of Example 3 shown in Figs. 3, and therefore, the description is omitted. The main electrode 33 and the control electrode 35 are formed on the front surface of the transistor device 5, and the control electrode 35 is disposed at a corner portion of the main electrode 33. Then, the conductive member 34 is connected to the main electrode 33 via a bonding material (not shown), and has a shape in which the conductive member is cut out above the control electrode 35. Due to this, the main electrode 33 as a high-heat-generating portion of the transistor device 5 is entirely covered with the conductive member 34 not having a hole or groove that prevents heat conduction, a heat-equalizing property of the transistor device 5 in the surface direction is improved, and the connection reliability of the connection terminal 36 formed of a copper ribbon and connected to the conductive member 34 is improved. Moreover, in ultrasonic bonding of the connection terminal 37 formed of an aluminum wire, since the control electrode is located at the corner portion, the conductive member 34 is less likely to collide with the guide or the cutter, and it is unnecessary to reduce the size of the conductive member 34. Therefore, a high heat-equalizing effect due to the conductive member 34 is obtained. In addition to a heat-equalizing effect in the transistor device alone as described above, since the wiring pattern 3 and the conductive members 32 and 34 are connected by means of copper ribbons that are independent of each other in the module of this example, and the ribbons can be attached more densely than when using a continuous linear copper ribbon, a heat-equalizing effect is obtained also in the entire module, and the connection reliability of the connection terminal is improved.

### [Example 5]

Fig. 6 shows a top view of a power semiconductor module as yet another embodiment of the invention. Except for the control electrode and the electrical connection portion thereof, members used are the same as those of Example 4 shown in Fig. 5, and therefore, the description is omitted. The main electrode 33 and the control electrode 35 are formed on the front surface of the transistor device 5, and the control electrode 35 is disposed at the corner portion of the main electrode 33. Then, the conductive member 34 is connected to the main electrode 33 via a bonding material (not shown), and a conductive member 61 is connected to the control electrode 35 via a bonding material (not shown). For the conductive member 34 and the conductive member 61, the same material, which is a material having a thermal conductivity higher in the direction horizontal to the electrode surface of the transistor device than in the direction vertical to the electrode surface, is used, and it is particularly preferable to use a material obtained by stacking layers having different thermal conductivities, such as a clad material of copper/invar/copper . In this embodiment, a material having a copper/invar/copper thickness ratio of 1:1:1 and a total thickness of 1 mm is used. However, since the control electrode is smaller than the main electrode, and the thermal stress occurring in a bonding portion between the conductive member 61 and the control electrode 35 is small, pure copper can also be used for the conductive member 61 instead of using a cladmaterial of copper/invar/copper whose thermal expansion rate is close to that of Si or SiC. Since the conductive member 61 acts as a buffer in ultrasonic bonding of a connection terminal 62, a copper ribbon that is bonded with a load and power higher than those for aluminum is used for the connection terminal 62. The same copper ribbon in terms of material as well as shape is used for the connection terminal 36 and the connection terminal 62, so that the time for an ultrasonic connection process can be shortened.

In this configuration, the control electrode is located at the corner portion of the main electrode, the main electrode is covered with the conductive member not having a hole or groove that interrupts a heat conduction path, and therefore, a high heat-equalizing effect is obtained. Moreover, when the connection terminal 62 is ultrasonic-bonded, the conductive member 34 is not an obstacle. Therefore, since it is unnecessary for the conductive member 34 to keep a distance from a bonding portion of the connection terminal 62 by reducing the size of the conductive member 34, a high heat-equalizing effect due to the conductive member 34 is obtained. Further, the wiring pattern 3 and the conductive members 32 and 34 are connected by means of copper ribbons that are independent of each other in the module of this example, and the ribbons can be attached more densely than when using a continuous linear copper ribbon. Therefore, a heat-equalizing effect is obtained also in the entire module, and the connection reliability of the connection terminal is improved.

### [Example 6]

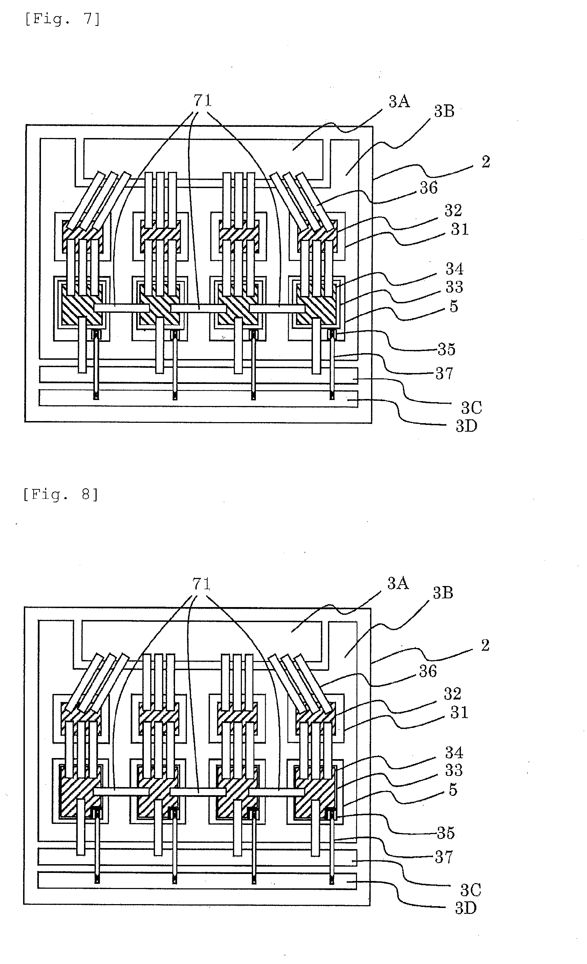

Fig. 7 shows a top view of a power semiconductor module as still another embodiment of the invention. Many members used are common with those of Example 3 shown in Figs. 3, and the description thereof is omitted. This example differs from Example 3 in that the conductive members 34 bonded to the main electrodes 33 of the transistor devices are connected to each other by means of a connection terminal 71. Since the conductive member 34 actsasabufferin ultrasonic bonding of the connection terminal 71, a copper ribbon that is bonded with a load and power higher than those for aluminum is used for the connection terminal 71. A copper wire or a clad wire of copper and aluminum can also be used. A technique to make the potentials equal to each other by connecting the transistor devices to each other by means of a connection terminal such as an aluminum wire is publicly known. However, a continuous line terminal that is stitch-bonded over a chip, like the connection terminal 44 in Figs. 4, inevitably covers the chip surface, so that it is difficult to ensure the area for connecting a wire or ribbon in a direction orthogonal to the terminal. In this example, since the connection terminals are disconnected on the conductive member 32 or 34, there is a sufficient space above the conductive member, wire or ribbon bonding in a different direction with the conductive member as a starting point is possible, and thus the conductive members 34 can be connected to each other.

As described above, the circuit board and the conductive member, and the conductive member and another conductive member are connected by means of connection terminals that are independent of each other, and stitch bonding on the conductive member on the transistor device is eliminated. Therefore, the transistor devices can be connected by means of a copper-containing material having an excellent heat transfer property, and heat conduction paths extend vertically and horizontally, which greatly contributes to heat equalization in the entire module.

### [Example 7]

Fig. 8 shows a top view of a power semiconductor module as still yet another embodiment of the invention. Members used are common with those of Example 6 shown in Fig. 7, and therefore, the description is omitted. The main electrode 33 and the control electrode 35 are formed on the front surface of the transistor device 5, and the control electrode 35 is disposed at the corner portion of the main electrode 33. Then, the conductive member 34 is connected to the main electrode 33 via a bonding material (not shown), and has a shape in which the conductive member is cut out above the control electrode 35. Due to this, the main electrode 33 as a high-heat-generating portion of the transistor device 5 is entirely covered with the conductive member 34 not having a hole or groove that prevents heat conduction, the heat-equalizing property of the transistor device 5 in the surface direction is improved, and the connection reliability of the connection terminal 36 is improved. Moreover, in ultrasonic bonding of the connection terminal 37, since the control electrode is located at the corner portion, the conductive member 34 is less likely to collide with the guide or the cutter, and it is unnecessary to reduce the size of the conductive member 34. Therefore, a high heat-equalizing effect due to the conductive member 34 is obtained. In addition to a heat-equalizing effect in the transistor device alone as described above, since the wiring pattern 3 and the conductive members 32 and 34 are connected by means of copper ribbons that are independent of each other in the module of the invention, the ribbons can be attached more densely than when using a continuous linear copper ribbon. Moreover, since a heat conduction path toward a direction different from the direction connecting the diode device 31 with the transistor device 5 is ensured by the connection terminal 71, further heat equalization in the entiremodule is possible, and the connection reliability of the wire or ribbon when operating at a high temperature is improved.

The embodiments of the invention have been specifically described using the examples. However, the invention is not limited to the configurations of the examples, and can be variously modified within the scope not departing from the gist of the invention.

### [Description of Reference Numerals and Signs]

1: heat sink
2: insulating substrate
3: wiring pattern
4: bonding material
5: transistor device
6: main electrode
7: control electrode
8: front surface electrode
9: bonding material
10: conductive member
11: connection terminal
12: connection terminal
21: bonding material
22: conductive member
23: connection terminal
31: diode device
32: conductive member
33: main electrode
34: conductive member
35: control electrode
36: connection terminal
37: connection terminal
41, 42, 43, 44: connection terminal
61: conductive member
62: connection terminal
71: connection terminal

## Claims

1. A power semiconductor module comprising:
a heat sink (1);
a circuit board connected to the heat sink (1) via a bonding material and formed with a wiring on a front surface of an insulating substrate (2);
a transistor device (5) including a main electrode (6) and a control (7) electrode formed on one surface and a back surface electrode formed on the other surface, the back surface electrode being connected to the circuit board via a bonding material;
a first conductive member (10) bonded to the main electrode (6) via a bonding material (9); and
wire or ribbon-shaped connection terminals (11, 12) electrically connecting the first conductive member (10) and the control electrode (7) with another device or the circuit board, wherein
the control electrode (7) is disposed at a corner portion of the main electrode (6), and
the first conductive member (10) has a shape in which the first conductive member (10) is cut out at a portion above the control electrode (7).

2. The power semiconductor module according to claim 1, wherein
a thermal conductivity of the first conductive member (10) in a direction horizontal to an electrode surface of the transistor device (5) is higher than a thermal conductivity of the first conductive member (10) in a direction vertical to the electrode surface.

3. The power semiconductor module according to claim 1 or 2, wherein
the first conductive member (10) is formed by stacking a plurality of layers having different thermal conductivities.

4. The power semiconductor module according to at least one of claims 1 to 3, wherein
the connection terminal (11, 12) is directly connected to the control electrode (7).

5. The power semiconductor module according to at least one of claims 1 to 4, further comprising a second conductive member (22) connected to the control electrode (7) via a bonding material (21), wherein
the control electrode (7) and the connection terminal (23) are electrically connected via the second conductive member (22).

6. The power semiconductor module according to claim 5, wherein
a thermal conductivity of the second conductive member (22) in a direction horizontal to an electrode surface of the transistor device (5) is higher than a thermal conductivity of the second conductive member (22) in a direction vertical to the electrode surface.

7. The power semiconductor module according to claim 5 or 6, wherein
the second conductive member (22) is formed by stacking a plurality of layers having different thermal conductivities.

8. The power semiconductor module according to at least one of claims 1 to 7, further comprising:
a diode device (31) connected to the circuit board via a bonding material; and
a third conductive member (32) connected to a front surf ace electrode of the diode device (31) via a bonding material, wherein
a first connection terminal that connects the circuit board with the first conductive member (10) or the third conductive member (32), and a second connection terminal that connects the first conductive member (10) with the third conductive member (32) are copper-containing wire or ribbon-shaped connection terminals that are independent of each other.

9. The power semiconductor module according to claim 8, wherein
a copper-containing wire or ribbon-shaped third connection terminal that connects the first conductive members to each other is provided.

10. A power semiconductor module comprising:
a heat sink (1);
a circuit board connected to the heat sink (1) via a bonding material and formed with a wiring on a front surface of an insulating substrate (2);
a transistor device (5) including a main electrode (6) and a control electrode (7) formed on one surface and a back surface electrode formed on the other surface, the back surface electrode being connected to the circuit board via a bonding material;
a first conductive member (10) bonded to the main electrode (6) via a bonding material (9);
a diode device (31) connected to the circuit board via a bonding material;
a third conductive member (32) connected to a front surf ace electrode of the diode device (31) via a bonding material; and
wire or ribbon-shaped connection terminals (11, 12) that electrically connect the first conductive member (10), the third conductive member (32), and the control electrode (7) with another device or the circuit board, wherein
a first connection terminal that connects the circuit board with the first conductive member (10) or the third conductive member (32), and a second connection terminal that connects the first conductive member (10) with the third conductive member (32) are copper-containing wire or ribbon-shaped connection terminals that are independent of each other.

11. The power semiconductor module according to claim 10, wherein
a copper-containing wire or ribbon-shaped third connection terminal that connects the first conductive members to each other is provided.

12. The power semiconductor module according to claim 10 or 11, further comprising a second conductive member (22) connected to the control electrode (7) via a bonding material (21), wherein
the control electrode (7) and the connection terminal (23) are electrically connected via the second conductive member (22).
